**Europäisches Patentamt**

**European Patent Office**

**Office européen des brevets**

(19)

(11) Publication number : **0 553 982 A1**

(12) # EUROPEAN PATENT APPLICATION

(21) Application number : **93300329.5**

(22) Date of filing : **19.01.93**

(51) Int. Cl.⁵ : **H01L 31/107, H01L 31/0352**

(30) Priority : **29.01.92 US 827777**

(43) Date of publication of application :
**04.08.93 Bulletin 93/31**

(84) Designated Contracting States :
**DE GB**

(71) Applicant : **GENERAL ELECTRIC COMPANY**
**1 River Road**
**Schenectady, NY 12345 (US)**

(72) Inventor : **Hilton, Gene Charles**
**47 Dove Street**
**Albany, New York 12210 (US)**
Inventor : **Kwasnick, Robert Forrest**
**1021 Millington Road**
**Schenectady, New York 12309 (US)**

(74) Representative : **Lupton, Frederick et al**
**LONDON PATENT OPERATION, G.E.**
**TECHNICAL SERVICES Co. INC., Essex**
**House, 12/13 Essex Street**
**London WC2R 3AA (GB)**

(54) Amorphous multilayer avalanche photodiode.

(57) A low noise avalanche photodiode has a heterostructure photosensitive body with a plurality of gain stages (150) adjoining a light absorption layer (140). The light absorption layer (140) is made of an amorphous photosensitive material such as intrinsic amorphous silicon and is thick enough so that substantially all light photons incident on the device are absorbed in this layer. Each gain stage (150) is made up of alternating layers of photosensitive material, such as intrinsic amorphous silicon and intrinsic silicon carbide. The noise of the device is lessened with respect to photodiodes in which the light is absorbed in gain stages as the charge generated by the absorption of the light photons and which is of the type (i.e., electrons or holes) selected to be amplified is exposed to the same number of gain stages. The thickness of the light absorption layer is also advantageously selected so that the assembled device has a capacitance within a predetermined range.

FIG. 1

EP 0 553 982 A1

## Field of the Invention

This invention relates generally to the field of light sensitive semiconductors and more particularly to amorphous silicon multilayer avalanche photodiodes.

## Background of the Invention

Photodetectors are commonly used in a number of solid state imaging devices such as facsimile machines and solid state radiation detectors in which it is necessary to convert an optical input signal into corresponding electrical signals. In typical solid state radiation detectors employed in medical diagnostic procedures, for example, incident radiation strikes a scintillator material that generates light photons when the incident radiation is absorbed. Photodetectors in turn generate electrical signals when struck by the light photons, and these electrical signals are used to produce a visual display or are otherwise analyzed.

In a typical solid state photodiode a layer of photosensitive material is disposed between a common electrode and an electrical contact pad. A biasing voltage is applied across the photosensitive material by the electrodes, and electrons or holes produced when light photons are absorbed in the photosensitive material are collected at electrodes having the opposite polarity of the charge. Typically the contact electrode is coupled to a data sampling circuit that periodically measures the charge collected on the electrode and resets the photodiode to a known charge condition for the start of the next sampling sequence.

Avalanche photodiodes (APDs) are typically used in low light devices. For example, in low energy level radiation imagers the absorption of the radiation in the scintillator does not produce enough light photons for a conventional photodiode to generate a useable electrical signal. Avalanche photodiodes provide internal amplification of the charge generated by absorption of a light photon to produce an output signal that can be processed more easily than that of a photodiode without internal gain, by sampling and amplification circuits. Avalanche multiplication can be achieved through the application of a high biasing voltage across the photosensitive material. Avalanche multiplication can also be achieved through the use of a superlattice or multilayer structure producing a series of electric field bands through which the charge generated by absorption of incident light passes as it migrates under the influence of the biasing potential to the electrode at which it is collected. Both of these approaches present practical difficulties in fabrication and or operation of imaging devices. For example, the use of high biasing voltages results in more noise generated by the device and requires more elaborate protection of the analysis circuitry from the high voltages. Multilayer or superlattice devices, on the other hand, are typically fabricated from crystalline materials, making it difficult to fabricate large area arrays having many APDs with uniform performance characteristics.

An APD fabricated with amorphous materials arranged in a heterostructure device was proposed by S. Jwo et al. in the article "Amorphous Silicon/Silicon Carbide Superlattice Avalanche Photodiodes," IEEE Transactions on Electron Devices, Vol. 35, August 1988, pp. 1279-1283. Jwo notes that the use of amorphous materials allows easier fabrication of a large area display having many photodiodes; allows a variety of peak response wavelengths by changing the composition and well-to-barrier widths of the heterostructure; and allows abrupt profile changes not possible in a single crystalline silicon. In the Jwo device, a superlattice structure is formed from alternating layers of substantially intrinsic amorphous silicon (i-Si) serving as a well layer and amorphous silicon carbide (SiC) serving as a barrier layer. This heterostructure is coupled to an indium tin oxide (ITO) common electrode through a p+ doped contact layer and to a contact electrode through an n+ doped contact layer. Light incident on the Jwo device passes through a substrate, the indium tin oxide (ITO) common electrode, the relatively thin p+ doped layer (200 Å) and then into the multilayer structure in which it is ultimately absorbed.

Noise in a heterostructure avalanche photodiode of the type described by Jwo arises from the fact that the amount of charge multiplication in a given gain stage is dependent on whether a larger or a smaller number of avalanche ionizations occur. Such noise is accounted for by statistically modifying the output signal to reflect the mean number of ionizations for the total number of gain stages. Additionally, the light incident on the Jwo device and similar heterostructure devices can be absorbed in any of the gain stages, i.e., the alternating silicon/silicon carbide layers of the heterostructure. The electrons produced in the absorption of the light are then multiplied by the remaining gain stages. Thus, due to the structure of the conventional heterostructure device, the amount of amplification undergone by charge produced in the absorption of the light photon is dependent on the position in the device at which the light is absorbed. For example, some number of photons will be absorbed in the first gain stage, and the charge generated in those absorption events undergoes amplification in all of the remaining gain stages. Other light photons will pass through the initial gain stage and will be absorbed farther into the device. The charge produced in absorption events occurring in gain stages farther into the device is only amplified by the remaining gain stages. As a result, in the Jwo device the amplification experienced by charge produced in an absorption event is a function of the layer or gain stage in the device at which the light photon is absorbed. Such variance in the amplification results in more noise in the output signal of the device.

The performance of a photodiode array is affected by both the noise of the individual photodiodes and the capacitances of the diodes. In accordance with physical laws relating capacitance to the distance separating the top and bottom contact layers in each of the photodiodes, the capacitance and hence the noise of the array can be reduced by separating the two electrodes by the maximum amount consistent with other device performance characteristics. Increased separation of the electrodes in the conventional heterostructure APDs required additional gain stages, which increase the gain beyond what is required, increase the noise, and also complicate fabrication of large scale devices.

SUMMARY OF THE INVENTION

The present invention is set forth in claim 1.

It is therefore a feature of this invention to provide a low noise avalanche photodiode constructed of amorphous material so that it is readily fabricated in large arrays.

It is a further feature of this invention to provide an avalanche photodiode in which substantially all change generated by the absorption of light photons in the photodiode is amplified by the same number of gain stages.

It is a further feature of this invention to provide a low noise, high gain avalanche photodiode that is readily fabricated to exhibit a selected capacitance.

A low noise heterostructure photodiode is provided that has a contact electrode, a transparent conducting contact, and a heterostructure photosensitive body having a light absorption layer adjoining a plurality of gain stages. The light absorption layer is of a selected thickness and disposed in the device so as to absorb substantially all of the light photons incident on the device, thereby substantially eliminating the absorption of light photons in the gain stages. The light absorption layer advantageously comprises substantially intrinsic amorphous silicon and each of the gain stages comprises a layer of substantially intrinsic amorphous silicon carbide adjoining a layer of intrinsic amorphous silicon. The heterostructure photosensitive body typically further comprises a hole blocking layer comprising n+ doped amorphous silicon disposed adjacent to the contact electrode and an electron blocking layer comprising p+ doped silicon disposed adjacent to the transparent conducting contact. Alternatively, other photosensitive materials, such as amorphous selenium, can be used to fabricate the light absorption layer and the gain stages.

The thickness of the light absorption layer is selected to absorb substantially all light photons incident on the device so that all charges generated by the absorption of the light photons are exposed to the same number of gain stages in the APD. The thickness of the light absorption layer is preferably additionally selected to provide a predetermined capacitance value for the assembled avalanche photodiode.

Brief Description of the Drawings

The features of the invention believed to be novel are set forth with particularity in the appended claims. The invention itself, however, both as to organization and method of operation, together with further objects and advantages thereof, may best be understood by reference to the following description in conjunction with the accompanying drawings in which like characters represent like parts throughout the drawings, and in which:

Figure 1 is a cross-sectional view of an avalanche photodiode fabricated in accordance with the present invention.

Figure 2 is an energy-band diagram of an avalanche photodiode fabricated in accordance with the present invention.

Detailed Description of the Preferred Embodiment

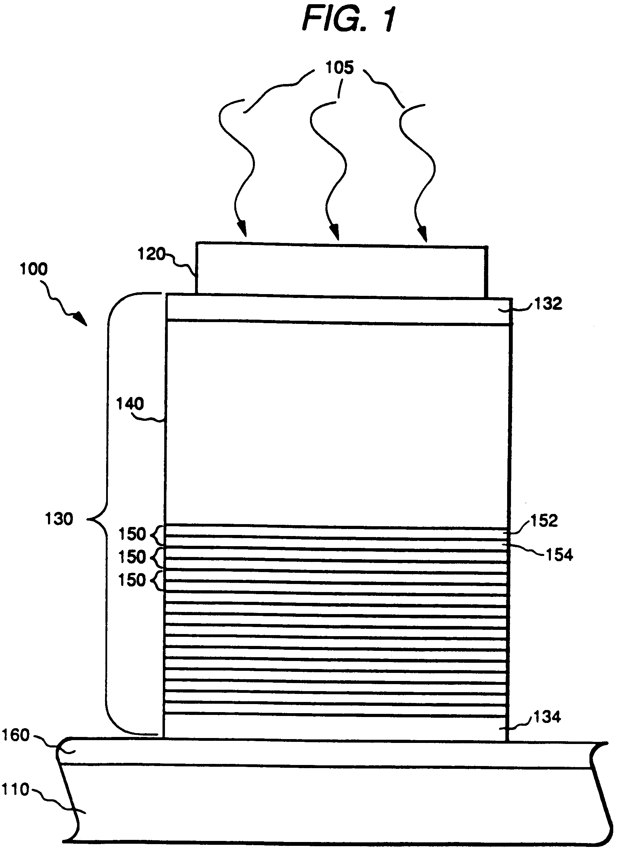

In Figure 1, a low noise heterostructure avalanche photodiode 100 exposed to incident light photons 105 is shown disposed on a substrate 110. Avalanche photodiode (APD) 100 comprises a transparent conducting contact 120, a heterostructure photosensitive body 130, and a contact electrode 160. Photosensitive body 130 comprises a light absorption layer 140 and a plurality of gain stages 150. In a typical imager device, a plurality of APDs 100 as described below are arranged in an array and electrically coupled to data sampling circuits for generating signals to operate visual displays or be used in other analysis of the detected light.

APD 100 is positionable so that incident light photons 105 enter the APD through transparent conducting contact 120, which is disposed in electrical contact with photosensitive body 130. Contact 120 typically comprises indium tin oxide (ITO) and has a thickness of between about 10 nm and 100 nm. Contact electrode 160 is disposed in electrical contact with the surface of photosensitive body 130 opposite the surface in contact with transparent conducting contact 120. Contact electrode 160 typically comprises chromium, aluminum, titanium, molybdenum or similar conductive material. The biasing voltage to drive the operation of APD 100 is applied across the photosensitive body by contact 120 and electrode 160.

Photosensitive body 130 advantageously comprises a electron blocking layer 132 disposed in electrical contact with conducting contact 120 and light absorption layer 140. Electron blocking layer 132 typically comprises p+ doped amorphous silicon having a thickness in the range between about 20 nm and 50 nm and doped to have a resistivity in the range between about 100 to 1000 ohm-cm. The electron blocking layer can alternatively comprise p+ doped amorphous silicon carbide, or a combination of p+ doped amorphous silicon and p+ doped amorphous silicon carbide. This layer substantially prevents the migration of electrons from the conducting contact 120 into photosensitive body 130.

In accordance with this invention, light absorption layer 140 is disposed between conducting contact 120 through which the incident light photons 105 enter the device and the plurality of gain stages 150. Light absorption layer 140 comprises a photosensitive material in which the light photons are absorbed with the resultant production of electric charge. The amount of the charge generated when the photosensitive material absorbs light corresponds with the intensity of the flux of light photons incident on the APD. The charge migrates within the light absorption layer under the influence of a biasing voltage applied across the photosensitive body by transparent conducting contact 120 and bottom contact 160. The photosensitive material advantageously comprises substantially intrinsic amorphous silicon. Alternative amorphous photosensitive materials, such as amorphous selenium, can be used provided electrical connections and appropriate associated coupling layers (e.g., hole and electron blocking layers) are correctly positioned to account for which carrier type, i.e., electron or holes, is selected to be amplified. For example, in devices comprising substantially intrinsic amorphous silicon as the photosensitive material, it is advantageous to amplify electrons, whereas in devices comprising amorphous selenium as the photosensitive material, it is advantageous to amplify holes.

In accordance with this invention, light absorption layer 140 has a selected thickness chosen so that substantially all light photons incident on the APD are absorbed in the light absorption layer and no light photons pass through layer 140 into the plurality of gain stages 150. The minimum selected thickness corresponds to the wavelength of the incident light and the characteristics of the photosensitive material, and is determined by the following relationship:

$$l = \log_e (1 - P) / -\alpha \quad \text{(Eqn 1 - 1)}$$

in which

$l$ = the minimum selected thickness (cm);

$P$ = % of photons absorbed in the selected distance; and

$\alpha$ = optical absorption (cm$^{-1}$).

Thus, for example, the thickness to absorb 99% of the incident photons would be determined by :

$$l = \log_e (1 - .99) / -\alpha, \text{ or} \quad \text{(Eqn 1 - 2)}$$
$$l = \log_e (.01) / -\alpha \quad \text{(Eqn 1 - 3)}$$

The optical absorption is a function of the incident photon energy and the photon wavelength (or frequency), and typically ranges from about 2 $\mu$m$^{-1}$ for red light (having a wavelength of about 650 nm and a photon energy of about 2 eV) to about 15 $\mu$m$^{-1}$ for blue light (having a wavelength of about 500 nm and a photon energy of about 2.5 eV). Thus, for red light, the selected minimum distance would be about 2500 nm and for blue light about 300 nm.

Additionally, in accordance with this invention, the selected thickness may be chosen to cause the fabricated APD to exhibit a desired capacitance. Thus, the thickness of light absorption layer 140 may advantageously be chosen to be thicker than the minimum selected thickness necessary to substantially absorb all incident light photons so that the capacitance of the completed APD is within a predetermined range. The capacitance associated with a selected thickness of the light absorption layer is expressed by the following relationship:

$$C = 8.85 \times 10^{-14}(A) (\varepsilon) / d \quad \text{(Eqn 2 - 1)}$$

in which

$C$ = photodiode capacitance;

$A$ = the area of the photodiode;

$\varepsilon$ = dielectric constant of the diode material; and

$d$ = the thickness of the diode.

For devices with amorphous silicon layers, the dielectric constant is about 12.

The deposition of intrinsic amorphous silicon is readily controlled in the fabrication process to achieve the desired selected thickness. The selected thickness of light absorption layer 140 typically is between about 500 nm and 2000 nm.

A plurality of gain stages 150 are disposed adjoining and electrically coupled to the light absorption layer. Each gain stage comprises a layer of substantially intrinsic amorphous silicon carbide (i-SiC) 152 adjoining a layer of substantially intrinsic amorphous silicon (i-Si) 154. Alternatively, in devices in which amorphous selenium is used as the photosensitive material, the gain stages advantageously comprise alternating layers of amorphous selenium and selenium telluride. Each alternating layer of i-Si and i-SiC has a thickness in the range between about 10 nm and 30 nm. The total number of gain stages is determined based upon the desired operating characteristics of the APD, most notably the desired avalanche amplification of the APD.

The plurality of gain stages adjoin and are electrically coupled to hole blocking layer 134, which is disposed between the plurality of gain stages 150 and contact electrode 160. Hole blocking layer 134 provides an electrical contact layer and blocks passage of electrons from contact electrode 160 into gain stages 150. Hole blocking layer 134 advantageously comprises n+ doped amorphous silicon and has a thickness in the range between about 20 nm and 50 nm and doped to have a resistivity in the range between about 100 and 1000 ohm-cm.

In operation, the heterostructure of alternating layers of i-Si and i-SiC in photosensitive body 130 provides an electric band structure that exhibits avalanche multiplication of electrons passing from the light absorption layer into the gain stages. In accordance with this invention, as substantially all light photons are absorbed in light absorption layer 140, substantially all electrons produced pass through the same number of gain stages as they migrate to contact electrode 160 under the influence of the biasing voltage applied across the APD.

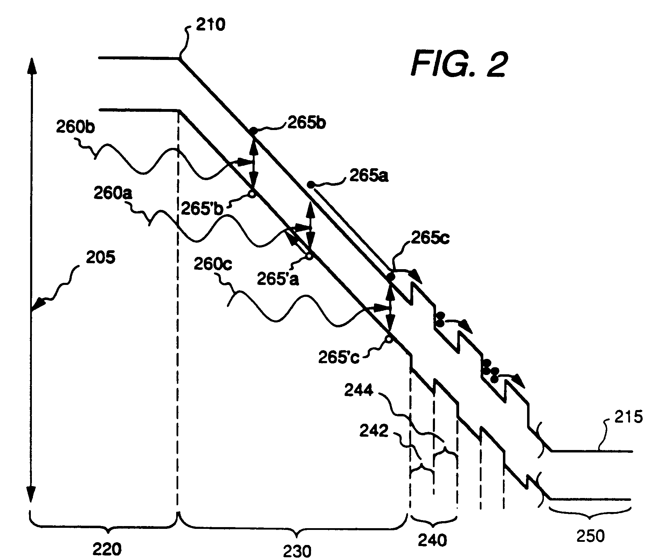

A simplified energy band diagram for the device is depicted in Figure 2 and is useful in illustrating operation of the device. For ease of description, a device comprising intrinsic amorphous silicon and i-SiC/i-Si gain stages is discussed, although the principles of operation of the device are the same in embodiments comprising other photosensitive materials. Biasing voltage 205 is graphically represented by the separation along the y-axis between the potential of the p+ contact 210 and the n+ contact 215. Length 220 along the x-axis corresponds to the thickness of the p+ contact; similarly length 230 corresponds to the thickness of the light absorption layer, lengths 240, 242, and 244 correspond to the thickness of one gain stage and its constituent i-SiC and i-Si layers respectively; and, length 250 corresponds to the thickness of the n+ contact layer. An incident light photon 260a absorbed in the light absorption layer causes the generation of charge, represented in Figure 2 by electron 265a and corresponding hole 265'a. The biasing voltage causes the electron to migrate towards the n+ contact layer 215 and the hole to migrate towards the p+ contact layer 210. Similarly, incident light photons 260b and 260c are absorbed in the light absorption layer causing the generation of charge, indicated in Figure 2 by representative electron 265b and corresponding hole 265'b and electron 265c and corresponding hole 265'c respectively. Electrons 265b and 265c migrate towards n+ contact layer 215, and holes 265'b and 265'c migrate towards p+ contact layer 210. Prior to reaching the n+ layer, electrons 265a, 265b, and 265c each pass through the plurality of gain stages 150, in which they undergo avalanche multiplication in accordance with known phenomena associated with heterostructure devices. Holes 265'a - 265'c drift towards p+ contact layer 210 without gain. In accordance with this invention, substantially all light photons are absorbed in the light absorption layer and thus all charge generated by the absorption of light and of the type selected to be amplified is exposed to amplification by the same number of gain stages.

While only certain features of the invention have been illustrated and described herein, many modifications and changes will occur to those skilled in the art. It is, therefore, to be understood that the appended claims are intended to cover all such modifications and changes as fall within the scope of the invention.

## Claims

1. A low noise heterostructure avalanche photodiode for detecting light, comprising:
    a contact electrode;
    a transparent conducting contact; and
    a heterostructure photosensitive body disposed between and in electrical contact with said electrode and said conducting contact;
    said heterostructure photosensitive body comprising a plurality of gain stages and a light absorption layer adjoining said gain stages, said light absorption layer having a selected thickness to absorb substantially all of said light incident on said photodiode prior to said light entering said gain stages.

2. The photodiode of claim 1 wherein each of said gain stages comprises a layer of substantially intrinsic amorphous silicon carbide adjoining a layer of substantially intrinsic amorphous silicon.

3. The photodiode of claim 2 wherein said light absorption layer comprises substantially intrinsic amorphous silicon.

4. The photodiode of claim 3 wherein said heterostructure photosensitive body further comprises a hole blocking layer disposed adjacent to said contact electrode and an electron blocking layer disposed adjacent to said transparent conducting contact.

5. The photodiode of claim 4 wherein said hole blocking layer comprises n+ doped amorphous silicon and said electron blocking layer comprises p+ doped amorphous silicon or amorphous silicon carbide.

6. The photodiode of claim 5 wherein said hole and electron blocking layers each has a thickness between about 20 nm and 50 nm.

7. The photodiode of claim 2 wherein each of said intrinsic amorphous silicon and silicon carbide layers in said gain stages has a thickness between about 10 nm and 30 nm.

8. The photodiode of claim 3 wherein said light absorption layer has a selected thickness between about 300 nm and 2500 nm.

9. The photodiode of claim 1 wherein the minimum thickness of said light absorption layer to absorb substantially all incident light photons is determined in accordance with the relation:

$$l = \log_e (1 - P) / - \alpha$$

in which

l = the minimum selected thickness (cm);

P = % of photons absorbed in the selected distance; and

$\alpha$ = optical absorption (cm$^{-1}$).

10. The photodiode of claim 2 wherein said light absorption layer is disposed between said plurality of gain stages and said transparent conducting contact so as to absorb substantially all light passing through said conducting contact before said light enters said gain stages.

11. The photodiode of claim 1 wherein each of said gain stages comprises a layer of amorphous selenium telluride adjoining a layer of amorphous selenium.

12. The photodiode of claim 11 wherein said light absorption layer comprises a layer of amorphous selenium.

13. The photodiode of claim 1 wherein said selected thickness of said light absorption layer is further selected to cause the assembled photodiode to exhibit a capacitance within a predetermined range.

# FIG. 1

*FIG. 2*

EP 0 553 982 A1

| European Patent Office | EUROPEAN SEARCH REPORT | Application Number |
|---|---|---|
| | | EP  93 30 0329 |

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5 ) |
|---|---|---|---|
| X | IEE PROCEEDINGS J. OPTOELECTRONICS vol. 138, no. 3, June 1991, STEVENAGE GB pages 226 - 234 CHANG ET AL. 'AMORPHOUS Si/SiC PHOTOTRANSISTORS AND AVALANCHE PHOTODIODES' * page 230, right column, paragraph 7 - page 233, left column, line 12; figure 7 * | 1-8,10 | H01L31/107 H01L31/0352 |
| A,D | IEEE TRANSACTIONS ON ELECTRON DEVICES vol. 35, no. 8, August 1988, NEW YORK US pages 1279 - 1283 JWO ET AL. 'AMORPHOUS SILICON/SILICON CARBIDE SUPERLATTICE AVALANCHE PHOTODIODES' * the whole document * | 1,2,4,5,6,7 | |
| A | PATENT ABSTRACTS OF JAPAN vol. 14, no. 187 (E-917)16 April 1990 & JP-A-20 34 977 ( MATSUSHITA ELECTRIC IND CO LTD ) 5 February 1990 * abstract * | 1,4,5 | |

TECHNICAL FIELDS SEARCHED (Int. Cl.5 )

H01L

The present search report has been drawn up for all claims

| Place of search | Date of completion of the search | Examiner |
|---|---|---|
| THE HAGUE | 22 APRIL 1993 | LINA F. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P0401)

9